# EUROPEAN PATENT APPLICATION

(11) **EP 1 607 983 A2**
(43) Date of publication of application: **21.12.2005**
(21) Application number: 05253456.7
(22) Date of filing: 04.06.2005
(51) Int. Cl.: G11C 13/04, G11B 7/125, G03H 1/26, G11B 7/0065

(54) **Angular and wavelength multiplexing apparatus for holographic storage**

(30) Priority: 09.06.2004 JP 2004171557
(71) Applicant: ALPS ELECTRIC CO., LTD., Ota-ku Tokyo 145 (JP)
(72) Inventor: Mytsuya, Shinji/Alps Electric Co. Ltd., Tokyo (JP)
(74) Representative: Kensett, John Hinton

(57) **Abstract**

A hologram device records/reproduces information on/from a recording medium (3) having holograms (4) thereon by irradiating light beams emitted from a light source (1) thereon. The light source (1) is composed of a substrate (10) and a plurality of light emitting units (11a,11b,11c) arranged on the substrate. A condensing unit (2) is provided between the light source and the recording medium (3) to condense a plurality of light beams (L0a,L0b,L0c) emitted from the plurality of light emitting units onto approximately the same location (4) of the recording medium.

## Description

### BACKGROUND OF THE INVENTION

### 1. Field of the Invention

The present invention relates to a hologram device that reproduces information from a recording medium having holograms thereon by irradiating light beams emitted from a light source thereon, and more specifically, to a hologram device which reproduces multi-recorded holograms.

### 2. Description of the Related Art

Conventionally, there have been known storage devices using a holographic principle. A hologram is formed on a recording medium by interference between an object beam and a reference beam. In order to reproduce the hologram, a reference beam having the same wavelength and angle as that used for writing is incident on the hologram to thereby reproduce original information.

A characteristic of a holographic storage medium is that it has high density and a large amount of capacity. In addition, an angular multiplexing method in which the angle of the reference beam varies, or a wavelength multiplexing method in which the wavelength of the reference beam varies can be used to perform multi-recording on information, which enables much higher density. As compared to conventional electronic storage devices which read out information in a sequential manner, holographic storage devices can read out the information in a page unit at a time. Thereby, high-speed data processing can be achieved.

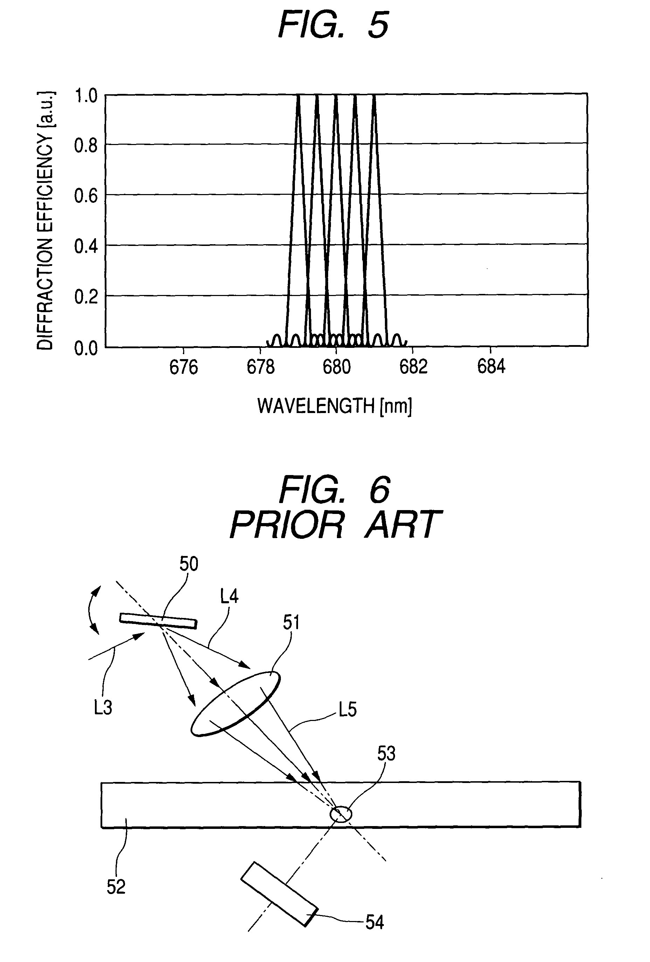

In the angular multiplexing method, conventional galvano mirrors have been used to vary the angle of the reference beam. FIG. 6 shows a conceptual view of an example in which the galvano mirror is used in a hologram device. As shown in FIG. 6, the hologram device includes a galvano mirror 50 for varying the angle of a reference beam and a condensing lens 51. A reference beam L3 emitted from a light source is reflected from the galvano mirror 50, and a reflected light beam L4 is incident on a hologram 53 on a recording medium 52 through the condensing lens 51. A light beam emitted from the hologram 53 is received by a light receiving element 54. The incidence angle of a light beam L5 with respect to the holograms 53 varies by the angle variation of the galvano mirror 50. A device for reproducing angle-multiplexed holograms using a galvano mirror as mentioned above is disclosed in Japanese Unexamined Patent Application Publication No. 2000-155950, for example.

However, in the conventional hologram devices, a complex driving unit for the galvano mirror and a control system for the driving unit have been needed in order to precisely control the irradiation angle of the reference beam with respect to the recording medium. For this reason, it has been difficult to miniaturize the hologram device and to reduce manufacturing costs thereof.

### SUMMARY OF THE INVENTION

The present invention is designed to solve the above problems, and it is an object of the invention to provide a multi-recording type hologram device having a simple mechanism, a small size, and a lower manufacturing cost.

According to an aspect of the invention, there is provided a hologram device that records/reproduces information on/from a recording medium having holograms thereon by irradiating light beams emitted from a light source thereon. In the hologram device, the light source is composed of a substrate and a plurality of light emitting units arranged on the substrate, and a condensing unit is provided between the light source and the recording medium to condense a plurality of light beams emitted from the plurality of light emitting units onto approximately the same location of the recording medium.

Further, in the hologram device according to the invention, it is preferable that the condensing unit be composed of a lens array including a plurality of condensing lenses respectively corresponding to the light emitting units and a collimator lens arranged behind the lens array.

Furthermore, in the hologram device according to the invention, it is preferable that each of the plurality of light emitting units arranged on the substrate be composed of a surface-emitting element.

In addition, in the hologram device according to the invention, it is preferable that the plurality of surface-emitting elements arranged on the substrate be arranged in an array.

Moreover, in the hologram device according to the invention, it is preferable that each of the light emitting units be composed of a wavelength-tunable light emitting element that selectively generates a light beam having one of a plurality of wavelengths.

### BRIEF DESCRIPTION OF THE DRAWINGS

FIG. 1 is a conceptual view showing a hologram device of the present embodiment;
FIG. 2 shows a perspective view of a light source;
FIG. 3 is a conceptual view showing a detailed configuration of a condensing unit;
FIG. 4 shows a perspective view of another light source;
FIG. 5 is a view showing a diffraction efficiency when a reference beam is irradiated onto a wavelength-multiplexed hologram varying the wavelength of the reference beam; and
FIG. 6 is a conceptual view showing a conventional hologram device.

### DESCRIPTION OF THE PREFERRED EMBODIMENT

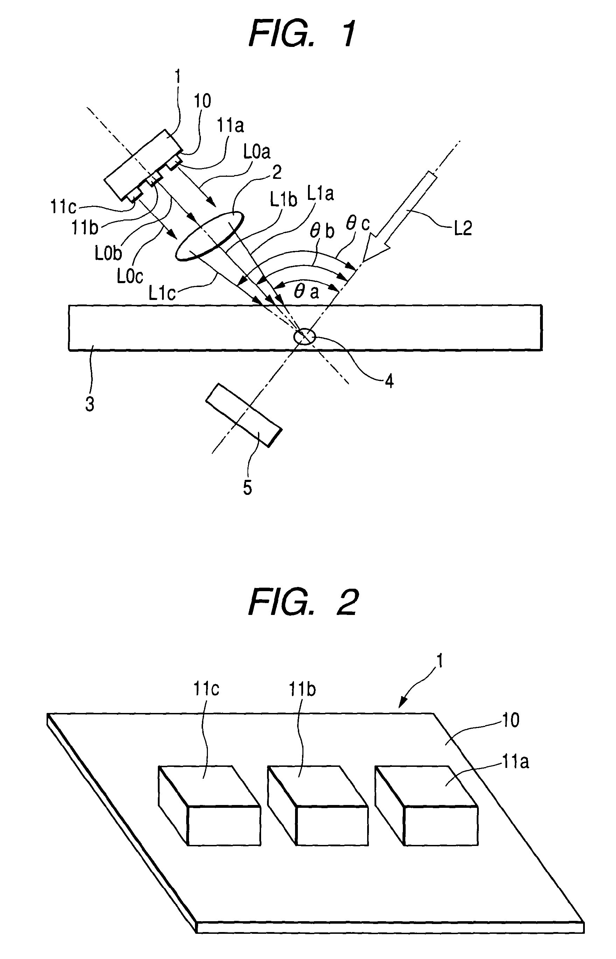

Hereinafter, a preferred embodiment of the present invention will be described in detail with reference to the drawings. FIG. 1 is a conceptual view showing a hologram device of an embodiment. As shown in FIG. 1, the hologram device is basically composed of a light source 1 having surface-emitting elements 11a, 11b, and 11c, a condensing unit 2 which condenses light beams emitted from the light source 1 onto a hologram 4 on a recording medium 3, and a light receiving unit 5 which receives light beams emitted from the hologram 4. The hologram device shown in FIG. 1 reproduces the hologram 4.

The hologram 4 on the recording medium 3 is formed by irradiating an object beam and a reference beam at a predetermined angle to generate interference fringe. Further, the recording medium 3 having the hologram 4 thereon may be duplicated. In order to read out information recorded on the recording medium 3, the same light beam as a reference beam used to form the hologram 4 is incident on the recording medium 3, and then the light beam is diffracted to reproduce an original image. The diffracted light is received by the light receiving unit 5 composed of, for example, a CMOS, and thus the information is read out. Also, the light receiving unit 5 may be composed of a CCD or the like.

Here, when the hologram 4 is formed, spatial multiplexing is performed in which the angle of the reference beam varies. In other words, the recording medium 3 can be written with a plurality of information items at the same location thereof by varying the angle of the reference beam when the hologram 4 is formed. In order to read out the information, a light beam having the wavelength of the reference beam used for writing is incident on the recording medium 3 at the same angle as when it is written, thereby reproducing each multiplexed hologram 4.

Next, a configuration of the light source 1 will be described. FIG. 2 shows a perspective view of the light source 1. As shown in FIG. 2, the light source 1 is composed of a plurality of light emitting units 11a, 11b, and 11c provided on a substrate 10. Each of the light emitting units 11a, 11b and 11c is composed of a surface-emitting element, more specifically, a surface-emitting laser. However, it is not limited thereto, but, for example, it is possible to use light beams from a light source provided at a different location using an optical fiber. In the present embodiment, an example will be described in which the light emitting units 11a, 11b, and 11c are arranged in a straight line at predetermined gaps. The light emitting units 11a, 11b, and 11c in the embodiment generate light components L0a, L0b, and L0c having the same single wavelength, respectively. In addition, since a surface-emitting laser is used as each of the light emitting units 11a, 11b, and 11c, the plurality of light emitting units 11a, 11b, and 11c can be formed on the substrate 10 simultaneously, and thus the cost of the light source 1 can be reduced. As a result, it is possible to implement an inexpensive hologram device. Also, each light emitting unit is not limited to the surface-emitting laser, but a Fabry-Perot type laser diode can be used.

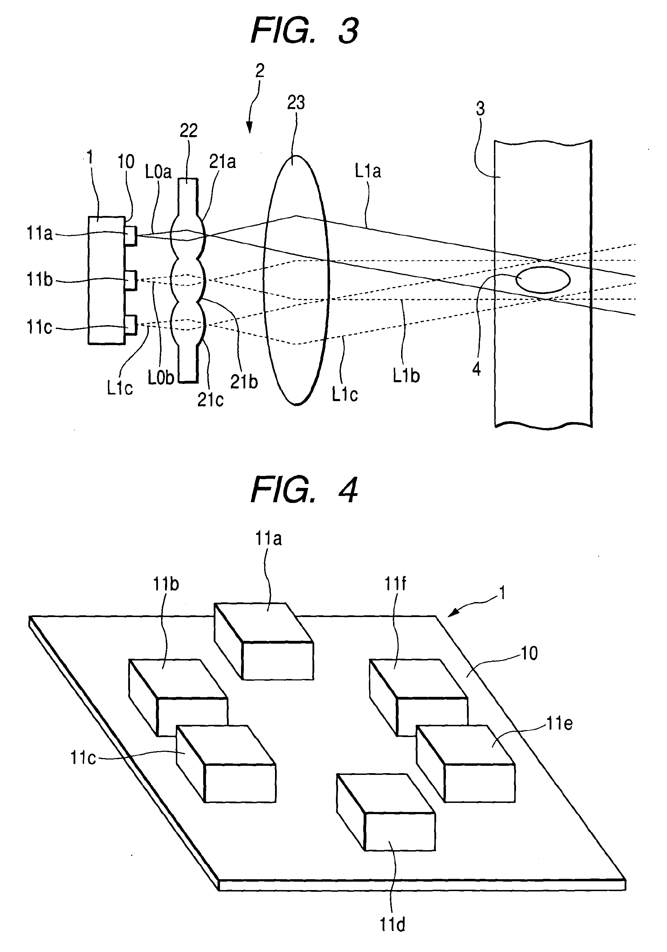

The condensing unit 2 condenses light beams emitted from the light source 1 onto approximately the same location of the recording medium 3, and the light beams L1a, L1b and L1c emitted from the condensing unit 2 become reference beams each reproducing the hologram 4. Here, FIG. 3 is a conceptual view showing a detailed configuration of the condensing unit 2 in the present embodiment.

As shown in FIG. 3, the condensing unit 2 is composed of a lens array 22 including a plurality of condensing lenses 21a, 21b, and 21c and a collimator lens 23 arranged behind the lens array 22. A light beam emitted from each of the light emitting units 11a, 11b, and 11c has the size corresponding to the hologram 4 by the lens array 22 to be incident on the collimator lens 23, and is then modified into a parallel light beam by the collimator lens 23 to be incident on the same location of the recording medium 3.

Each of the condensing lenses 21a, 21b, and 21c constituting the lens array 22 is a lens which focuses incident light beams on a focal point with a predetermined convergent angle. That is, first, each of the condensing lenses 21a, 21b, and 21c converges a light beam emitted from the corresponding one of the light emitting units 11a, 11b, and 11c onto the focal point, and then modifies the light beam into a divergent light beam at the point. Then, the light beam is incident on the collimator lens 23 with the beam diameter corresponding to the size of the hologram 4. Here, in order to facilitate the location decision of an optical system with respect to the hologram 4, the diameter of a light beam incident on the collimator lens 23 is larger than that of a light beam incident on the hologram 4.

The light beam emitted from each of the light emitting units 11a, 11b, and 11c has a small output angle. Therefore, when the light beam is directly incident on the collimator lens 23 without passing through the lens array 22 interposed therebetween, the distance between the light source 1 and the collimator lens 23 should be large, so that the beam diameter can correspond to the size of the hologram 4. However, since the beam diameter of a light beam at the collimator lens 23 can be enlarged by providing the lens array 22, the distance between the light source 1 and the collimator lens 23 can be narrowed. Thus, the entire device can be made small.

The collimator lens 23 modifies light beams diverging in a propagating direction into parallel light beams each of which stands in line, and at the same time, makes the light beams incident on predetermined locations, respectively. In the present embodiment, a monocrystalline aspheric lens is used as the collimator lens 23. Further, the collimator lens 23 is provided behind the lens array 22, and has the size in which light beams having transmitted the condensing lens 21a, 21b, and 21c can be incident, respectively. Since the light beams incident on the collimator lens 23 are divergent light beams, they are modified into parallel light beams to thereby be incident on the same location of the recording medium 3, respectively. In other words, the light beams having transmitted the collimator lens 23 are incident, at different angles, on the hologram 4 which is formed on the recording medium 3 to have a predetermined width corresponding to the hologram 4, respectively.

Next, the reproduction of a hologram multi-recorded by angular multiplexing will be described in detail. As shown in FIG. 1, the light emitting units 11a, 11b, and 11c of the light source 1 emit light beams from different locations, respectively. Therefore, light beams L1a, L1b, and L1c which are incident on the recording medium 3 through the condensing unit 2 are incident on the hologram 4 at different angles, respectively.

The light beam L0a emitted from the light emitting unit 11a changes its propagating direction by the condensing unit 2 to become the light beam L1a, and then the light beam L1a is incident on the hologram 4 under the condition in which the angle between the light beam L1a and the object beam L2 with respect to the hologram 4 is θa. The light beam L0b emitted from the light emitting unit 11b passes through the condensing unit 2 to become the light beam L1b, and then the light beam L1b is incident on the hologram 4 under the condition in which the angle between the light beam L1b and the object beam L2 with respect to the hologram 4 is θb. The light beam L0c emitted from the light emitting unit 11c changes its propagating direction by the condensing unit 2 to become the light beam Llc, and then the light beam L1c is incident on the hologram 4 under the condition in which the angle between the light beam L1c and the object beam L2 with respect to the hologram 4 is θc.

When the light beams emitted from the light emitting units 11a, 11b, and 11c are simultaneously incident on the hologram 4, a plurality of information items are reproduced at the same time, but the information can not be separated in the light receiving unit 5. Therefore, the light beams from the light source 1 are output by sequentially emitting the light emitting units 11a, 11b, and 11c, and thus the information of the multi-recorded hologram 4 is sequentially read out for each angle.

For the light source 1, the number of light emitting units 11a, 11b, and 11c and the arrangement thereof are not limited to those shown in FIG. 2. Another example of the light source 1 is shown in FIG. 4. In FIG. 4, light emitting units 11a, 11b, 11c, 11d, 11e, and 11f are arranged on a substrate 10 in a circular shape. In addition to the circular shape, a cross shape, an elliptical shape, a square shape or the like may be considered as patterns of the arrangement. In any case mentioned above, the light source 1 is constructed by arranging the light emitting units 11a, 11b, 11c, 11d, 11,e and 11f on the substrate 10 in an array.

Next, the reproduction of the hologram 4 recorded by a combination of the angular multiplexing and the wavelength multiplexing will be described in detail. In this case, the basic configuration is the same as that in FIG. 1. That is, light beams emitted from the light source 1 in which the light emitting units 11a, 11b, 11c, 11d, 11e, and 11f are arranged on the substrate 10 in an array are incident on the recording medium 3 through the condensing unit 2. Thereby, the light beam emitted from each of the light emitting units 11a, 11b, 11c, 11d, 11e, and 11f is incident on the hologram 4 at a different angle. Thus, it is possible to read out the angle-multiplexed information separately.

In the configuration of FIG. 1, the multi-recordable number is determined by the number of light emitting units 11a, 11b, and 11c, and multiplexing more than the number is not possible. On this account, by configuring each of the light emitting units 11a, 11b, and 11c constituting the light source 1 with a wavelength-tunable light source, the effects of the angular multiplexing and the wavelength multiplexing can be combined, and the number of data multiplexing can be further increased.

In the present embodiment, each of the light emitting units 11a, 11b, and 11c is a wavelength-tunable light source in which a light beam having one of a plurality of wavelengths can be selectively generated. Also, each of the light emitting units 11a, 11b, and 11c has the same center wavelength, and accordingly, it is possible to vary the wavelength within the same range with respect to the wavelength-tunable range. Here, as the wavelength-tunable light source, there are various wavelength-tunable light sources, such as a wavelength-tunable light source in which an injection current is changed to vary the oscillation wavelength, a wavelength-tunable light source in which temperature is changed to vary the oscillation wavelength, a wavelength-tunable light source in which an external resonator is provided and the length of the resonator is changed to vary the oscillation wavelength. However, only if the wavelength is tunable, any type of wavelength-tunable light source can be used.

FIG. 5 shows diffraction efficiency when a reference beam is irradiated onto the wavelength-multiplexed hologram 4 varying the wavelength of the reference beam. As shown in FIG. 5, the hologram 4 has each peak of diffraction efficiency with respect to five different wavelengths. In other words, five data are multiplexed in the hologram 4, and a light beam having one of the five different wavelengths is selected in the light emitting units 11a, 11b, and 11c to be irradiated onto the hologram 4, and thus wavelength-multiplexed information can be read out.

When the light source 1 is configured in this way, the three light emitting units 11a, 11b, and 11c can read out five data, respectively. As a result, the multiplexing number of holograms becomes fifteen. Specifically, in the light source 1 including the plurality of light emitting units 11a, 11b, and 11c, each of the light emitting units 11a, 11b, and 11c is composed of a wavelength-tunable light source. Accordingly, even though the multiplexing number is small due to the narrow wavelength-tunable range of the light emitting units 11a, 11b, and 11c, it is possible to make a sharp increase in the multiplexing number. Thereby, the recording density of information in the recording medium 3 can be increased.

According to the hologram device of the invention, a light source composed of a plurality of light emitting units and a condensing unit which condenses a plurality of light beams emitted from the light emitting units are provided, so that the irradiation angle of the reference beam varies easily only by changing the emission location of a light emitting element. Thereby, it is possible to perform angular multiplex recording on a hologram with respect to a recording medium and the reproduction of the hologram. Accordingly, a complex mechanism including a galvano mirror and a driving system therefor is not necessary, which makes a device simple. As a result, the miniaturization of the hologram device and a reduction in manufacturing costs can be realized. Also, the reliability of a device can be enhanced by making the device simple.

Further, according to the hologram device of the invention, the condensing unit is composed of a lens array including a plurality of condensing lenses, each corresponding to each of the light emitting units, and a collimator lens arranged behind the lens array. Accordingly, it is possible to uniformly irradiate the reference beam corresponding to the size of the hologram 4 onto the same location of the recording medium 3.

Furthermore, according to the hologram device of the invention, each of the plurality of light emitting units is composed of a surface-emitting element, so that it is possible to simultaneously form the plurality of light emitting units on a substrate, which leads to a reduction in the manufacturing costs of the light source. Thereby, it is possible to implement an inexpensive hologram device.

In addition, according to the hologram device of the invention, the plurality of surface-emitting elements arranged on the substrate is arranged in an array, and accordingly, it is possible to form a light emitting pattern suitable for the reproduction of the hologram.

Moreover, according to the hologram device of the invention, each of the light emitting units is composed of a wavelength-tunable light emitting element in which a light beam having one of a plurality of wavelengths is selectively generated. Accordingly, in addition to angular multiplex recording by the plurality of light emitting units, wavelength multiplex recording by each of the light emitting units is practicable, thereby further increasing the recording density of information in the recording medium.

Having described the embodiment of the present invention, it is to be understood that the invention is not limited thereto, but various changes and modifications thereof can be made without departing from the spirit and scope of the invention.

## Claims

1. A hologram device that records/reproduces information on/from a recording medium (3) having holograms (4) thereon by irradiating light beams emitted from a light source (1) thereon,
**characterized in that** the light source (1) is composed of a substrate and a plurality of light emitting units (11a, 11b, 11c) arranged on the substrate, and
a condensing unit (2) is provided between the light source (1) and the recording medium (3) to condense a plurality of light beams emitted from the plurality of light emitting units (11a, 11b, 11c) onto approximately the same location of the recording medium (3).

2. The hologram device according to claim 1,
**characterized in that** the condensing unit (2) is composed of a lens array (22) including a plurality of condensing lenses (21) respectively corresponding to the light emitting units (11a, 11b, 11c) and a collimator lens (23) arranged behind the lens array (22).

3. The hologram device according to claim 1 or 2,
**characterized in that** each of the plurality of light emitting units (11a, 11b, 11c) arranged on the substrate is composed of a surface-emitting element.

4. The hologram device according to claim 3,
**characterized in that** the plurality of surface-emitting elements arranged on the substrate is arranged in an array.

5. The hologram device according to any one of claims 1 to 4,
**characterized in that** each of the light emitting units (11a, 11b, 11c) is composed of a wavelength-tunable light emitting element that selectively generates a light beam having one of a plurality of wavelengths.
